# FASCICULE DE BREVET EUROPEEN

(11) **EP 2 218 072 B1**
(45) Date de publication et mention de la délivrance du brevet: **13.05.2015**
(21) Numéro de dépôt: 08864600.5
(22) Date de dépôt: 04.12.2008
(51) Int. Cl.: G11C 11/16

(54) **ELEMENT MAGNETIQUE A ECRITURE ASSISTEE THERMIQUEMENT**
WÄRMEUNTERSTÜTZTES MAGNETISCHES SCHREIBELEMENT
THERMALLY-ASSISTED MAGNETIC WRITING ELEMENT

(30) Priorité: 05.12.2007 FR 0759584
(43) Date de publication de la demande: 18.08.2010
(73) Titulaire: Commissariat à l'Énergie Atomique et aux Énergies Alternatives, 75015 Paris (FR); Centre National de la Recherche Scientifique, 75794 Paris Cedex 16 (FR); CROCUS Technology, 38025 Genoble (FR)
(72) Inventeur: PREJBEANU, Lucian, F-38360 Sassenage (FR); MAUNOURY, Cécile, F-38100 Grenoble (FR); DIENY, Bernard, F-38250 Lans En Vercors (FR); DUCRUET, Clarisse, F-38000 Grenoble (FR); SOUSA, Ricardo, F-38000 Grenoble (FR)
(74) Mandataire: Vuillermoz, Bruno
(86) Numéro de dépôt international: PCT/FR2008/052204
(87) Numéro de publication internationale: WO 2009/080939

(56) Documents cités:
- EP-A- 1 486 967
- EP-A- 1 693 854
- US-A1- 2006 152 967

## Description

### DOMAINE TECHNIQUE

La présente invention se rattache au domaine des éléments magnétiques à jonction tunnel magnétique ou à vanne de spin, tels que ceux utilisés dans les mémoires magnétiques à accès aléatoire non volatiles, permettant, de manière connue, le stockage, la lecture et l'écriture de données dans les systèmes électroniques. Plus spécifiquement, elle s'applique aux mémoires magnétiques à accès aléatoire, désignées de manière traditionnelle sous l'acronyme MRAM, constituées d'un ensemble de points mémoire formés chacun par une jonction tunnel magnétique, également désignée sous l'acronyme JTM. De manière connexe, la présente invention se rattache aussi aux éléments logiques à couches magnétiques dès lors qu'ils utilisent au moins une jonction tunnel magnétique ou une vanne de spin.

Dans ce qui suit, on entend donc par « élément magnétique » un empilement de couches magnétiques comportant au moins une couche piégée, une couche libre et entre celles-ci une couche isolante ou semi-conductrice ou à chemins de courant confinés. La définition de la notion de couche piégée et de couche libre apparaîtra de manière plus précise dans la suite de la présente description.

### ETAT ANTERIEUR DE LA technique

Les mémoires magnétiques MRAM ont connu un regain d'intérêt avec la mise au point de jonctions tunnel magnétiques (JTM) présentant une forte magnétorésistance à température ambiante. Ces mémoires magnétiques à accès aléatoire présentent en effet de nombreux atouts :
- rapidité comparable à celle des SRAM (quelques nanosecondes de durée d'écriture et de lecture),
- densité comparable à celle des DRAM,
- non volatilité, comme les mémoires flash,
- absence de fatigue à la lecture et à l'écriture,
- insensibilité aux radiations ionisantes, problème de plus en plus aigu en raison de la réduction des dimensions des transistors élémentaires.

Ce faisant, elles sont susceptibles de remplacer les mémoires de technologie plus traditionnelles basées sur l'état de charge d'une capacité (DRAM, SRAM, flash) et ainsi devenir une mémoire universelle.

Dans les premières mémoires magnétiques réalisées, celles-ci sont constituées d'un ensemble de points mémoire ou cellules mémoire, constitués chacun d'un élément dit "à magnétorésistance géante", constitué d'un empilement de plusieurs couches métalliques alternativement magnétiques et non magnétiques.

On a par exemple décrit ce type de structure dans les documents US 4 949 039 et US 5 159 513 pour les structures de base, et dans le document US 5 343 422 pour la réalisation d'une mémoire RAM à partir de telles structures de base.

Cette technologie, de par son architecture, permet la réalisation de mémoires non volatiles avec une technologie simple, mais cependant de capacité limitée. En effet, le fait que les éléments mémoire ou points mémoire soient connectés en série le long de chaque ligne, limite la possibilité d'intégration, puisque le signal est de plus en plus faible lorsque le nombre d'éléments ou points mémoire augmente.

La mise au point des points mémoire à jonction tunnel magnétique JTM a permis l'augmentation significative des performances et du mode de fonctionnement de ces mémoires. De telles mémoires magnétiques à jonction tunnel magnétique ont par exemple été décrites dans le document US-A-5 640 343. Dans leurs formes les plus simples, elles sont composées de deux couches magnétiques de coercitivités différentes, séparées par une couche mince isolante. Lorsque les aimantations des couches respectives de stockage et de référence, constituant les deux couches magnétiques précitées situées de part et d'autre de la barrière tunnel, sont anti-parallèles, la résistance de la jonction tunnel magnétique est élevée. A l'inverse, lorsque les aimantations sont parallèles, cette résistance devient faible.

De manière préférentielle, ces deux couches magnétiques sont réalisées à base de métaux 3d (Fe, Co, Ni) et leurs alliages (susceptibles de contenir du bore ou du zirconium de telle sorte à rendre amorphe la structure desdites couches et d'aplanir leurs interfaces), et la couche isolante est traditionnellement constituée d'alumine amorphe (AlOₓ) ou d'oxyde de magnésium cristallin (MgO). Avantageusement, la couche de référence, également dénommée « couche piégée », peut elle-même être constituée d'un empilement de plusieurs couches, tel que par exemple décrit dans le document US-5 583 725 et ce, afin de constituer une couche dite « anti-ferromagnétique synthétique » (SAF). De même, il est possible de remplacer pour chacun des points mémoire la jonction tunnel magnétique unique par une double jonction tunnel magnétique, tel que par exemple décrit dans la publication Y. SAITO & al, Journal of Magnetisum and Magnetic Materials », Volume 223, 2001, page 293. Dans ce cas, la couche de stockage est interposée entre deux couches isolantes, la structure comportant deux couches de référence positionnées sur les faces opposées auxdites couches isolantes respectives.

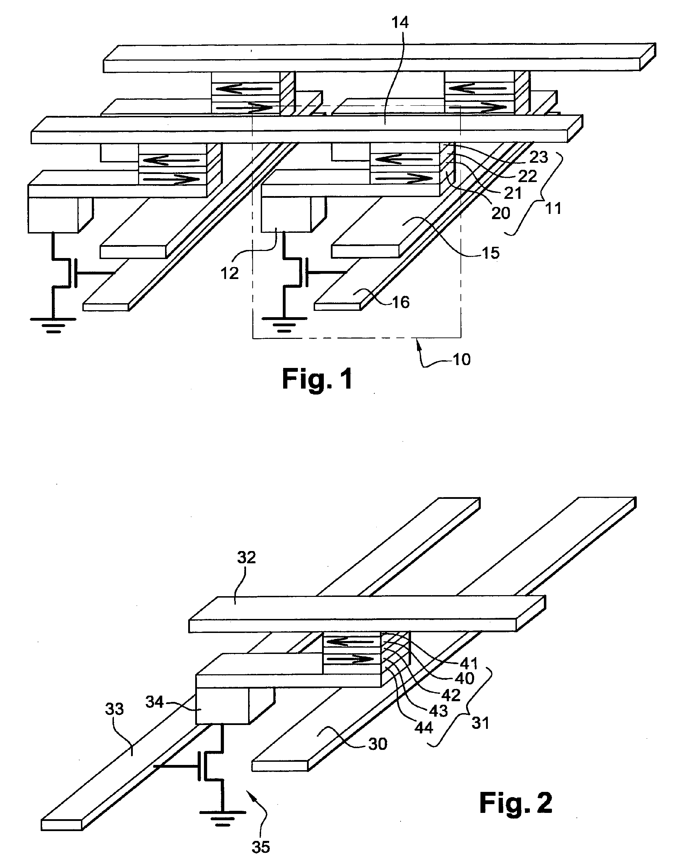

L'architecture la plus classique dite "FIMS", acronyme de l'expression anglo-saxonne *« Field Induced Magnetic Switching* », c'est-à-dire le renversement de l'aimantation par un champ magnétique induit, est celle décrite dans le document US-A-6 021 065 et dans la publication *"*journal of Applied Physics" vol. 81, 1997, page 3758 et représentée sur la figure 1.

Comme on peut l'observer au sein de la figure 1 illustrant l'état antérieur de la technique, chaque élément mémoire ou point mémoire (10) est constitué de l'association d'un transistor de technologie CMOS (12) et d'une jonction tunnel magnétique JTM (11). Ladite jonction tunnel (11) comporte au moins une couche magnétique (20), appelée « couche de stockage » ou « couche libre », une fine couche isolante (21), et une couche magnétique (22) dite "couche piégée", également dénommée couche de référence.

Le fonctionnement de ces mémoires magnétiques à points mémoire, constitués chacun d'une jonction tunnel magnétique, consiste, notamment pour l'écriture, à générer un champ magnétique d'origine impulsionnelle créé par des lignes de courant ou conducteurs associés à chacun desdits points magnétiques.

Ainsi, et dans le cadre de l'architecture FIMS, on observe trois niveaux de ligne de courant. Dans la figure 1, les deux niveaux de ligne (14) (*Word line*) et (15) (*Bit line*), généralement disposés à 90° l'un de l'autre, sont destinés à générer des impulsions de champ magnétique permettant la commutation de l'aimantation de la couche libre (20) lors du processus d'écriture. Ces impulsions de champ magnétique sont produites en faisant circuler dans les lignes de courant (14) et (15), des impulsions électriques courtes, typiquement 2 à 5 nanosecondes, et d'intensité de l'ordre de plusieurs milliampères. L'intensité de ces impulsions et leur synchronisation sont ajustées, de sorte que seule l'aimantation du point mémoire situé à la croisée de ces deux lignes de courant soit susceptible de commuter.

Un niveau de ligne de courant additionnel (16), également dénommé *"Control line"* est destiné à commander l'ouverture ou la fermeture du canal des transistors de sélection ou de commutation (12) associé à chaque point mémoire, afin de pouvoir adresser chaque élément mémoire individuellement. En d'autres termes, les transistors (12) CMOS sont utilisés comme des interrupteurs.

En mode écriture du point mémoire considéré, le transistor (12) sélectionné est en mode bloqué ou OFF, aucun courant ne traverse donc le transistor. On envoie une impulsion de courant I dans les deux lignes de courant (14) et (15) correspondant au point mémoire (10) sélectionné. L'amplitude de l'impulsion de courant I est telle que le champ magnétique créé ne soit pas suffisant pour faire basculer les points mémoire sur les lignes (14) ou (15), sauf à l'intersection des lignes (14) et (15) où la contribution conjointe des deux lignes est suffisante pour générer un champ magnétique également suffisant, susceptible de faire basculer l'aimantation de la couche (20) du point mémoire considéré.

En mode lecture, le transistor (12) est en mode saturé ou ON par l'envoi d'une impulsion de courant positive dans la grille dudit transistor à travers la ligne de commande (16), le courant qui le traverse étant maximum. Un courant de mesure est ensuite envoyé dans la ligne de courant (14) qui ne peut traverser que le seul point mémoire dont le transistor (12) est placé en mode saturé ou ON. Par ce courant, on effectue une mesure de la résistance de la jonction tunnel magnétique (11) dudit point mémoire (10) sélectionné. Par comparaison avec un point mémoire de référence (non représenté), l'état correspondant du point mémoire (10) "0" (pour une configuration à aimantation parallèle de faible résistance) ou "1"(pour une configuration d'aimantation anti-parallèle de résistance élevée) peut alors être déterminé.

On aura compris à la lumière de ce qui précède que l'intensité des impulsions traversant les lignes de courant (14) et (15) et leur synchronisation sont ajustées de telle sorte que seule l'aimantation du point mémoire se trouvant à l'intersection de ces deux lignes de courant (point sélectionné) peut commuter sous l'effet du champ magnétique généré par les deux conducteurs. Les autres points mémoire situés sur la même ligne ou sur la même colonne (points demi-sélectionnés) ne sont de fait assujettis qu'au champ magnétique d'un seul des conducteurs (14, 15), et en conséquence ne se retournent pas.

De par le mécanisme d'écriture de ces points mémoire, on est à même de comprendre les limites de cette architecture.

Dans la mesure où l'écriture est assurée par un champ magnétique extérieur, elle est assujettie à la valeur du champ de retournement individuel de chaque point mémoire. Comme la fonction de distribution des champs de retournement pour l'ensemble des points mémoire est large (en effet, elle n'est pas uniforme en raison des contraintes de fabrication et des fluctuations statistiques intrinsèques), il est nécessaire que le champ magnétique sur le point mémoire sélectionné soit supérieur au champ de retournement le plus élevé de la distribution, au risque de renverser accidentellement certains points mémoire situés sur la ligne ou sur la colonne correspondante, où le champ de retournement situé dans la partie basse de la distribution est plus faible que le champ magnétique généré par la ligne ou la colonne seule. Au surplus, la consommation électrique de la mémoire mettant en oeuvre un tel champ magnétique extérieur sera d'autant plus importante que la distribution du champ de retournement sera large.

De plus, attendu qu'en général, la valeur moyenne du champ de retournement augmente lorsque la taille des points mémoire diminue, ce que l'on tend à obtenir pour des raisons d'encombrement, un courant d'autant plus important est attendu dans les générations de produits futurs. En conséquence, la puissance électrique requise pour le fonctionnement de ces mémoires sera d'autant plus grande que l'intégration sera poussée.

Un autre inconvénient de ces mémoires de l'état de l'art concerne la stabilité de l'aimantation de la couche libre vis-à-vis des fluctuations thermiques lorsque la taille du point mémoire diminue. En effet, la barrière d'énergie à franchir pour faire commuter l'aimantation de cette couche d'une orientation à l'autre est proportionnelle au volume de cette couche. Lorsque le volume diminue, la hauteur de la barrière devient alors comparable à l'agitation thermique. L'information écrite dans la mémoire n'est alors plus conservée. Pour pallier cette difficulté, on est obligé d'augmenter l'anisotropie magnétique de la couche libre en choisissant un matériau de plus forte anisotropie ou en accentuant l'anisotropie de forme du point mémoire, par exemple. Mais ce faisant, le champ magnétique nécessaire à la commutation magnétique augmente, dû à une consommation électrique accrue pour générer le champ nécessaire à la commutation magnétique. Le courant électrique dans la « *word line* » et dans la « *bit line* » peut même, dans certains cas, excéder le seuil limite imposé par l'électromigration dans ces lignes conductrices (typiquement de l'ordre de 10⁷ A/cm²).

Aussi, afin de surmonter cette difficulté, on a proposé la mise en oeuvre de mémoires magnétiques à accès aléatoire à écriture assistée thermiquement, dénommées selon l'acronyme TAS-MRAM, dans laquelle la couche libre ou couche de référence est elle-même piégée par une couche anti-ferromagnétique. Ce perfectionnement est par exemple décrit dans le document US 6 385 082.

Dans cette configuration, au lieu de réaliser la sélectivité à l'écriture du point mémoire en combinant deux impulsions perpendiculaires de champ magnétique, cette sélectivité à l'écriture est réalisée en combinant une élévation de température courte du point mémoire à adresser, réalisée par une impulsion de courant traversant ledit point mémoire considéré, avec soit une impulsion de champ magnétique, soit par transfert de spin réalisé par un courant polarisé en spin à travers la couche de stockage dudit point mémoire.

On a représenté au sein de la figure 2 une telle configuration. Dans celle-ci, la couche libre (40) de la jonction tunnel magnétique (31) est piégée par une couche anti-ferromagnétique (41). De même que dans le cas des mémoires FIMS, une couche isolante (42) est comprise entre la couche libre magnétique (40) et une couche magnétique (43) dite "couche piégée". Selon cette configuration, les deux couches magnétiques sont avantageusement réalisées en des métaux de transition 3d (Fe, Co, Ni) et leurs alliages, dopées ou non (du bore notamment), et la couche isolante peut être de l'alumine ou de l'oxyde de magnésium. Selon une version avantageuse, la couche magnétique piégée (43) est couplée à une couche anti-ferromagnétique (44), dont la fonction est de piéger la couche (43) afin que son aimantation ne bascule pas lors de l'écriture.

Là encore, la couche anti-ferromagnétique (44) peut être une couche anti-ferromagnétique synthétique constituée de plusieurs couches.

Selon cette configuration, la couche anti-ferromagnétique (41) possède une température limite dite « de blocage » T_{B} au dessus de laquelle le champ magnétique dit « d'échange » stabilisant qu'elle exerce sur la couche libre (40) n'est plus effectif sur la couche libre (40). On sélectionne le matériau constituant la couche anti-ferromagnétique (41) ainsi que son épaisseur, de telle sorte que la température de blocage T_{B} soit supérieure à la température d'utilisation de la mémoire (température de fonctionnement au repos). De la même manière, on sélectionne la température de blocage T_{B} de la couche anti-ferromagnétique (44) adjacente à la couche piégée (43) afin qu'elle soit supérieure et assez éloignée de la température de blocage de la couche anti-ferromagnétique (41).

Ainsi, à une température inférieure à la température de blocage de la couche anti-ferromagnétique (41), la couche libre (40) est stabilisée par le champ magnétique d'échange, et ainsi elle s'avère très difficile à retourner par la seule application d'un champ magnétique externe ou par transfert de spin réalisé par un courant polarisé en spin à travers la couche libre. A la température de blocage de la couche anti-ferromagnétique (41) et au-delà, le champ d'échange étant nul, la couche libre (40) devient alors très facile à retourner par l'intermédiaire d'un champ magnétique externe, à condition que ce dernier soit supérieur au champ coercitif de la couche libre (40) à la température donnée, ou par transfert de spin avec une densité de courant polarisé en spin traversant la couche libre suffisamment forte pour provoquer la commutation magnétique. De fait, on choisit pour la couche libre (40) un matériau permettant à cette dernière d'avoir un champ coercitif faible si la commutation est réalisée par un champ magnétique, ou une faible densité de courant critique de commutation si la commutation est faite par transfert de spin.

Cette architecture particulière comporte deux ou trois niveaux de ligne de courant suivant que la commutation est réalisée par transfert de spin ou par champ magnétique. Pour l'écriture par champ magnétique, une ligne de courant (30) dite « ligne de champ », est située sous la jonction tunnel magnétique (31) sans cependant être en contact avec cette dernière. Elle est destinée à générer le champ magnétique nécessaire au renversement de la couche libre de stockage (40), dès lors qu'un courant électrique de plusieurs milliampères la traverse. Cette ligne n'existe pas si la commutation est réalisée par transfert de spin. Une autre ligne de courant (32) dite « *Bit line* », située au-dessus de la jonction tunnel magnétique (31) du point mémoire considéré et en contact avec celle-ci. Une troisième ligne de courant (33) dite *« Word line »* est en contact, par l'intermédiaire d'un via (34), avec un transistor CMOS (35), dont la *« word line* » constitue la grille. De même que pour le FIMS, la *« word line »* commande l'ouverture ou la fermeture du canal des transistors sur toute sa longueur par l'application ou non d'une tension seuil, chacun des transistors fonctionnant en mode interrupteur pour chacun des points mémoire associés.

En mode lecture, le transistor CMOS (35), associé au point mémoire à lire, est fermé par l'application d'une tension adéquate dans la *« mord line »* (33). Un courant de mesure est alors envoyé par la « *bit line* » (32), courant qui ne peut traverser que le seul point mémoire dont le transistor (35) est fermé (passant). Par ce courant, on effectue une mesure de la résistance de la jonction tunnel magnétique (31) du point mémoire sélectionné. Par comparaison avec un point mémoire de référence (non représenté), l'état correspondant du point mémoire "1" ou "0" est ainsi déterminé, l'état "1" correspondant par exemple au maximum de résistance et l'état "0" au minimum.

En mode écriture, le transistor CMOS (35) du point mémoire à écrire est fermé par l'intermédiaire de l'application d'une tension adéquate dans la « *word line* » (33). Un courant de chauffage d'une intensité supérieure au courant de mesure est alors envoyé dans le point mémoire à écrire par la « *bit line »* (32). A partir d'une certaine densité de courant, celui-ci induit l'élévation de température de la jonction tunnel magnétique (31) au-dessus de la température de blocage de la couche anti-ferromagnétique (41). Le champ d'échange stabilisant la couche libre (40) devient alors nul, et ladite couche libre est alors très mobile. Pour une commutation magnétique par champ magnétique, une impulsion électrique de plusieurs milliampères et d'une durée de quelques nanosecondes est alors envoyée dans la ligne de champ (30) une fois que la température de blocage est atteinte (au bout de quelques nanosecondes). Cette impulsion génère un champ magnétique suffisant pour retourner dans le sens souhaité (écriture du bit "1" ou "0"), la couche libre (40), qui comme décrit précédemment, est très mobile avec une coercitivité intrinsèque faible. Une fois que la couche libre (40) a été écrite, le courant électrique dans la ligne de champ (30) est alors coupé, le champ magnétique d'écriture devient nul et on coupe alors le courant de chauffage dans la jonction tunnel magnétique (31) (par coupure du courant dans la *« bit line »* (32) et ouverture du transistor (35)). La température globale du point mémoire chute alors très rapidement (quelques nanosecondes) en deçà de la température de blocage de la couche anti-ferromagnétique (41) (à la température de fonctionnement au repos typiquement), et le champ d'échange reprend alors sa valeur initiale, stabilisant du coup la couche libre (40).

Pour une commutation par transfert de spin, on se sert du courant de chauffage à la fois pour chauffer la couche de stockage de la jonction tunnel et pour appliquer un couple de transfert de spin sur l'aimantation de cette couche. Pour faire commuter l'aimantation de la couche de stockage, le flux d'électrons du courant de chauffage doit aller de la couche de référence vers la couche de stockage ce qui signifie que le courant de chauffage doit aller de la couche de stockage vers la couche de référence. Au contraire, pour faire commuter l'aimantation de la couche de stockage vers l'état antiparallèle, il faut que le flux d'électrons du courant de chauffage aille de la couche de stockage vers la couche de référence ce qui signifie que le courant de chauffage doit aller de la couche de référence vers la couche de stockage.

Le document US2006/152967 décrit une mémoire du même type, dans laquelle la couche de stockage peut être réalisée en un alliage ferromagnétique amorphe.

De telles mémoires magnétiques à écriture assistée thermiquement présentent un certain nombre d'avantages, parmi lesquels on peut citer :
- amélioration significative dans la sélectivité à l'écriture du fait que seul le point mémoire à écrire est chauffé ;
- conservation de l'information écrite dans la mémoire même lorsque le point mémoire est exposé à des champs magnétiques parasites à température ambiante ;
- amélioration de la stabilité thermique de l'information par la mise en oeuvre de matériaux avec une forte anisotropie magnétique (intrinsèque, et due à la forme du point mémoire ou au champ d'anisotropie d'échange de la couche de stockage), à température ambiante ;
- possibilité de réduire de manière significative la taille des cellules des points mémoire sans affecter leur limite de stabilité de par l'utilisation de matériaux avec une forte anisotropie magnétique à température ambiante ou à couche de stockage piégée par anisotropie d'échange;
- réduction de la consommation lors de l'écriture ;
- possibilité d'obtenir des cellules de stockage multi-niveaux dans certaines circonstances.

Il a été également montré que la même technologie pouvait être utilisée pour réaliser des éléments logiques tels que des portes logiques reprogrammables (voir par exemple la publication « Evaluation of a non-volatile FPGA based on MRAM technology » de Zhao-W; Belhaire-E; Javerliac-V; Chappert-C; Dieny-B, Proceedings.-2006-International-Conference-on-Integrated-Circuit-Design-and-Technology. 2006: 4 pp, IEEE, Piscataway, NJ, USA). Ces éléments logiques combinent aussi des composants semi-conducteurs en technologie CMOS avec des jonctions tunnels magnétiques comme les MRAMs sus-décrites. Contrairement aux mémoires dont le but est de stocker l'information, ces éléments logiques servent à traiter ces informations et à effectuer des opérations logiques sur ces informations. Souvent, les jonctions tunnel magnétiques sont utilisées dans ces éléments comme des résistances variables permettant de changer les seuils de commutation des circuits CMOS.

L'objet de la présente invention concerne autant les MRAMs à écriture assistée thermiquement que ces éléments logiques dans lesquelles les configurations magnétiques des jonctions tunnel sont modifiées par écriture par champ ou par transfert de spin assistée thermiquement.

Nonobstant ces avantages, on se heurte cependant, à certaines difficultés sur le plan de la technologie de fabrication.

Ainsi, dans le cadre des mémoires magnétiques à écriture assistée thermiquement mettant en oeuvre des jonctions tunnel magnétique dont la couche isolante est à base d'alumine, on utilise comme couche anti-ferromagnétique destinée à piéger la couche de stockage un alliage à base de manganèse, et notamment de l'IrMn et du FeMn. La mise en oeuvre d'une telle couche n'a pas d'influence sur le ratio de magnétorésistance. Ce résultat est principalement inhérent au caractère amorphe de l'alumine constituant la barrière tunnel de la jonction tunnel magnétique. Ce caractère amorphe est en outre préservé après la phase de recuit requise de l'empilement ainsi réalisé, recuit nécessaire pour conférer une orientation déterminée du champ polarisant d'échange à l'interface entre la couche de piégeage anti-ferromagnétique et la couche de référence ferromagnétique. Ce caractère amorphe n'a pas d'influence sur la texture de la couche anti-ferromagnétique supérieure (IrMn) pour générer un champ d'anisotropie d'échange élevé. De fait, la valeur de magnétorésistance d'une jonction tunnel magnétique à base d'alumine n'est pas affectée lorsque l'on met en oeuvre une telle couche supérieure anti-ferromagnétique.

Cependant, la situation est tout autre lorsqu'on utilise des jonctions tunnel magnétiques à base d'oxyde de magnésium cristallin ou texturé.

En premier lieu, il convient de rappeler que l'utilisation d'une jonction tunnel magnétique mettant en oeuvre une barrière tunnel à base d'oxyde de magnésium permet d'améliorer significativement les amplitudes de magnétorésistance. On a montré que cette amélioration était inhérente à la structure cristalline de la barrière tunnel en MgO et des couches ferromagnétiques adjacentes. Aussi bien la barrière tunnel MgO que les couches ferromagnétiques adjacentes doivent être monocristallines ou hautement texturées avec une organisation cristallographique cubique centré (001) de telle sorte qu'un effet de filtrage symétrique et dépendant du spin puisse intervenir à travers la barrière tunnel. On obtient ainsi des ratios de magnétorésistance largement supérieurs à 100 % à la température ambiante avec des jonctions tunnel magnétiques, dans lesquelles on met en oeuvre :
▪ des couches ferromagnétiques cubiques centrées Fe, Co ou CoFe ;
▪ ou des jonctions texturées incluent des couches ferromagnétiques CoFe ou Co polycristalline également cubique centré
▪ ou avec un empilement CoFeB/MgO/CoFeB avec un dépôt amorphe CoFeB.

Dans ce dernier cas, la barrière tunnel MgO croît avec une texture cubique centrée très orientée au niveau de son interface avec la couche inférieure amorphe CoFeB. Le processus de recuit thermique réalisé après le dépôt de l'empilement est requis pour induire une recristallisation locale selon une orientation cristalline cubique centrée des couches magnétiques en contact avec la barrière tunnel MgO. Corollairement, le recuit fixe le champ magnétique polarisant d'échange de la couche de référence.

Il résulte de ces différentes constatations que les propriétés de magnéto-transport dépendantes du spin sont différentes selon que la jonction tunnel magnétique est réalisée à base d'alumine ou d'oxyde de magnésium. Le filtrage en spin basé sur la symétrie des fonctions d'ondes électroniques, caractéristiques d'une structure cristalline texturée de la barrière tunnel et des couches ferromagnétiques adjacentes, donne lieu à des valeurs de magnétorésistance plus élevées. Ce filtrage est également plus sensible aux disparités structurelles entre les différentes couches de l'empilement. Dans le cas spécifique des jonctions tunnel magnétiques, dont la barrière tunnel est en MgO, le dépôt de la barrière tunnel MgO présentant une texture cristalline cubique centrée implique la croissance également d'une couche ferromagnétique supérieure avec une structure cristalline identique, de telle sorte à assurer une valeur de TMR élevée, basée sur l'effet de filtrage par la barrière tunnel, des électrons selon leur spin.

Or, et ainsi que rappelé précédemment, dans le cas de la mise en oeuvre d'une couche de stockage polarisée par champ d'échange pour les mémoires magnétiques à écriture assistée thermiquement, on doit déposer sur la face supérieure de ladite couche de stockage une couche anti-ferromagnétique à faible température de blocage. Le plus souvent, cette couche anti-ferromagnétique est organisée selon une structure cristallographique cubique face centrée, de façon à conférer un champ polarisant d'échange élevé. Ce faisant, on se heurte à une incompatibilité cristallographique entre les deux types de structure requise respectivement pour la barrière tunnel et pour la couche anti-ferromagnétique supérieure, se traduisant par des effets négatifs sur le ratio de magnétorésistance et sur l'anisotropie d'échange de la couche de stockage.

De fait, on se heurte à la difficulté de faire coexister dans le même empilement, une tricouche constituée de : ferromagnétique inférieure /barrière tunnel MgO/couche magnétique supérieure présentant un ratio de magnétorésistance élevé et de structure cubique centrée avec une bicouche supérieure constituant les couches de stockage ferromagnétiques/anti-ferromagnétiques avec un champ d'anisotropie d'échange élevé obtenu pour une structure cubique face centrée, alors même que ces deux entités présentent une structure cristallographique préférentielle différente.

Il va de soi que bien que la discussion précédente ait été basée sur le cas de jonction tunnels magnétiques impliquant la présence d'une barrière tunnel séparant la couche de référence de la couche de stockage, les mêmes problématiques d'adaptation de structures cristallographiques se présentent dans le cas de l'utilisation de couches séparatrices semi-conductrices (par exemple en germanium, silicium ou GaAs) ou de couches séparatrices métal/oxyde hétérogènes comme les couches dites à chemins de courant confinés développées dans le contexte des têtes de lecture magnétorésistives de disques durs. Ces dernières sont préparées par exemple par oxydation de couches minces d'alliages Al₁₋ₓCuₓ avec x de 0,5 à 10%.

### EXPOSE DE L'INVENTION

La présente invention a justement pour but de proposer de telles mémoires magnétiques à accès aléatoire ou éléments logiques à écriture assistée thermiquement par champ ou par transfert de spin, mettant en oeuvre plus particulièrement comme point mémoire une jonction tunnel magnétique dont la barrière tunnel est réalisée en MgO en raison de ses caractéristiques magnétiques, et notamment dans le but de disposer simultanément d'un haut rendement de magnétorésistance et de bonnes propriétés de piégeage de la couche de stockage.

A cet effet, on doit pouvoir disposer des différentes caractéristiques suivantes de l'empilement constitutif de la jonction tunnel magnétique :
- faible température de blocage et champ magnétique d'échange élevé pour la couche de stockage, au moins supérieur au champ coercitif de ladite couche de stockage ;
- deux distributions de température de blocage bien séparées respectivement pour la couche de stockage et la couche de référence ;
- ratio de magnétorésistance élevé et faible produit de la surface par la résistance (inférieur à 100 Ω.µm²) de façon à obtenir une plage de lecture élevée et pour permettre un chauffage efficace lors de la phase d'écriture sans pour autant excéder la tension de claquage de la barrière tunnel.

A cet effet, la présente invention vise une mémoire magnétique ou un élément logique à écriture par champ ou par transfert de spin assistée thermiquement, à base d'éléments magnétiques, chacun comprenant :
- une couche magnétique de référence, dite « couche piégée », dont l'aimantation est de direction fixe ;
- une couche magnétique de stockage, dite « couche libre », dont la direction de l'aimantation est variable, et constituée d'une couche réalisée en un matériau ferromagnétique à aimantation dans le plan de la couche, couplée magnétiquement avec une couche de piégeage en un matériau anti-ferromagnétique ;
- une couche isolante, semi-conductrice ou à chemins de courant confinés interposée entre la couche de référence et la couche de stockage.

Selon l'invention, on interpose au sein de la couche de stockage, entre la couche ferromagnétique et la couche anti-ferromagnétique, une ou plusieurs bicouches constituées respectivement d'un matériau amorphe ou quasi-amorphe et d'un matériau de même structure ou de même réseau cristallographique que la couche anti-ferromagnétique.

Ce faisant, de par l'intercalage au sein de la couche de stockage d'une couche en matériau amorphe ou quasi-amorphe, c'est-à-dire d'un matériau dénué de toute orientation ou structure cristallographique ou dont l'ordre local d'organisation cristallographique est inférieur ou égal au nanomètre, on rend compatibles les réseaux cristallographiques respectivement de la barrière tunnel et de la couche anti-ferromagnétique constituant la couche supérieure de la couche de stockage, et corollairement, on aboutit aux différentes caractéristiques mentionnées précédemment.

Selon l'invention, l'épaisseur de la couche ou des couches réalisées en matériau amorphe ou quasi-amorphe est comprise entre 0,15 et 3 nm.. La valeur 0,15 nm est donnée à titre indicatif comme une valeur minimale pour permettre la transition de structures entre cubique centrée et cubique face centrée. La valeur 3 nm est aussi donnée à titre indicative comme étant une valeur maximale au delà de laquelle les couches magnétiques de part et d'autre de cette couche amorphe ou quasi amorphe pourraient être trop magnétiquement découplées si la couche amorphe est non-magnétique. Si la couche amorphe est magnétique (comme par exemple en CoFeB), la valeur de 3 nm est aussi une valeur maximale pour ne pas excessivement augmenter l'épaisseur magnétique de la couche de stockage.

Le matériau amorphe ou quasi-amorphe est avantageusement choisi dans le groupe comprenant le tantale (Ta), le cuivre (Cu), le ruthénium (Ru), la silice (SiO₂), l'oxyde de tantale (TaO), les oxydes d'aluminium (AlOₓ), les oxydes de zirconium (ZrOₓ), les oxydes de titane (TiOₓ), les oxydes de hafnium (HfOₓ), le nitrure de tantale (TaN), le nitrure de titane (TiN), les métaux de transition Co, Fe ou Ni avec ajout de bore, de zirconium, de niobium ou d'hafnium dans des proportions totales d'éléments ajoutés de 5 à 30% atomique ou un alliage de ces composés

Selon l'invention, le dépôt de ce matériau amorphe ou quasi-amorphe peut-être réalisé par pulvérisation cathodique ou tout autre procédé de dépôt de phase vapeur (PVD : Physical Vapor Deposition)

Selon une variante de l'invention, le matériau amorphe ou quasi-amorphe est constitué d'un oxyde de métal hétérogène.

Celui-ci est par exemple constitué par oxydation d'une fine couche d'alliage cuivre-aluminium (Al₁₋ₓCuₓ), x étant compris dans une fourchette de 0,1 à 10 %, et de manière plus générale, les alliages hétérogènes répondant à la formule M_{y}(NOₓ)_{1-y}, dans laquelle :
▪ M représente un métal de transition choisi dans le groupe comprenant le nickel, le cobalt et le fer, ou un métal noble ou un alliage de métaux nobles, tel que le cuivre, l'argent ou l'or,
▪ NOₓ représente un oxyde amorphe ou quasi-amorphe d'un élément choisi dans le groupe comprenant Si, Ti, Hf, Ta, Mg ou un mélange de ces oxydes ; la notation NOx indique que la composition de l'oxyde est proche d'une composition stable de l'oxyde correspondant (par exemple SiO₂, Al₂O₃, Ta₂O₅, HfO₂) mais avec la possibilité de la présence de lacunes d'oxygène.
▪ y est compris entre 0.1 et 10%

Avantageusement et selon l'invention, les couches anti-ferromagnétiques piégeant respectivement la couche de référence et la couche de stockage sont réalisées à base d'alliage de manganèse, et notamment PtMn pour la couche de référence, et IrMn ou FeMn pour la couche de stockage.

### BREVE DESCRIPTION DES DESSINS

La manière dont l'invention peut être réalisée et les avantages qui en découlent ressortiront mieux de l'exemple de réalisation qui suit, donné à titre indicatif et non limitatif à l'appui des figures annexées.
La figure 1 est, comme déjà dit, une représentation schématique de l'architecture d'une mémoire magnétique de type FIMS de l'état antérieur de la technique.
La figure 2, également déjà décrite, est une représentation schématique d'une mémoire magnétique mettant en oeuvre une mémoire MRAM à écriture assistée thermiquement, également connue de l'état antérieur de la technique.
La figure 3 est une représentation schématique d'un point mémoire mis en oeuvre dans le cadre de la mémoire magnétique à écriture assistée thermiquement de la figure 2, donc appartenant également à l'état antérieur de la technique.
La figure 4 est une vue d'un point mémoire partiel conforme à la présente invention.

### DESCRIPTION DETAILLEE DE L'INVENTION

On a abondamment décrit dans le préambule de la présente invention l'état antérieur de la technique relative aux mémoires magnétiques à accès aléatoire. Ce faisant, et dans l'objectif de simplifier la présente description, seul un point mémoire constitutif de telles mémoires magnétiques va être décrit ci-après plus en détail.

Comme déjà dit, celui-ci est fondamentalement constitué d'un élément magnétique magnétorésistif, préférentiellement une jonction tunnel magnétique. Celle-ci comporte une barrière tunnel (42) sélectionnée dans le groupe comprenant les oxydes d'aluminium AlOₓ, de titane TiOₓ et l'oxyde de magnésium MgO.

Alternativement, la couche séparant la couche de référence (43) de la couche de stockage (40) peut être de nature semi-conductrice (par exemple à base de silicium ou de germanium ou en GaAs).

Elle peut aussi être constituée d'une couche métal/oxyde hétérogène comme les couches à chemins de courant confinés (selon l'expression aglo-saxonne « current confined paths ») développées dans le contexte des têtes de lecture magnétorésistives pour disques durs. Ces dernières sont par exemple constituées d'alliages Al₁₋ₓCuₓ avec x compris entre 0,5 et 10% que l'on oxyde, formant une couche d'alumine amorphe percée de trous métalliques de cuivre.

Il est bien connu que les jonctions tunnel magnétique présentent une capacité limitée en termes de tension susceptible d'être appliquée à leurs bornes en raison des risques de claquage électrique. En conséquence, il est nécessaire de réduire suffisamment le produit RA résistance x surface pour permettre le passage d'un courant électrique à travers la barrière tunnel lui-même suffisamment élevé pour induire une élévation de température de la couche de stockage de la jonction tunnel au-dessus de sa température de blocage.

En fonction de la nature des empilements utilisés pour la jonction tunnel magnétique, la densité du courant de chauffage requise pour élever la température de la jonction tunnel magnétique d'environ 150°C peut varier entre 10⁵A/cm² jusqu'à 10⁷A/cm², selon qu'il y ait ou pas de barrière thermique et selon l'efficacité (la résistance thermique) de telles barrières (déterminées par leur épaisseur et par leur conductivité thermique). Ainsi, un produit RA (résistance x surface) de l'ordre de 1 à 500 Ω.µm² s'avère adapté pour de telles densités de courant.

Comme déjà dit, on peut mettre en oeuvre comme matériau de la barrière tunnel des oxydes d'aluminium notamment l'alumine avec une épaisseur comprise entre 0,7 et 1.2 nm ou l'oxyde de magnésium MgO avec une épaisseur comprise entre 1.0 et 2.5 nm.

Cependant, et afin d'obtenir des ratios de magnétorésistance élevés, typiquement supérieurs à 100 %, la mise en oeuvre de l'oxyde de magnésium comme barrière tunnel s'avère nécessaire. On a pu démontrer que ces propriétés de magnétorésistance étaient directement corrélées à sa structure cristallographique cubique centrée (001) ainsi qu'à la structure identique des couches ferromagnétiques en contact avec ladite barrière tunnel.

Avantageusement, la couche ferromagnétique de référence (43), située sur l'une des faces de la barrière tunnel (42), opposée à la face comprenant la couche de stockage (40), est constituée d'une couche synthétique constituée d'un empilement de deux couches ferromagnétiques couplées de manière anti-parallèle à travers une couche de ruthénium, la seconde couche ferromagnétique étant elle-même piégée par une couche anti-ferromagnétique typiquement réalisée en PtMn.

Alternativement, cette couche de référence peut être constituée par une couche ferromagnétique piégée par une couche anti-ferromagnétique.

L'épaisseur de la couche anti-ferromagnétique de piégeage PtMn de la couche de référence est relativement importante, typiquement entre 12 nm et 20 nm et présente une température de blocage élevée.

De la même façon, la couche de stockage (40), ci-après décrite plus en détail conformément à l'invention, est elle-même piégée par une couche anti-ferromagnétique (41) en l'espèce réalisée en IrMn ou FeMn, d'épaisseur plus fine que la couche de PtMn de piégeage de la couche de référence. Cette couche anti-ferromagnétique de piégeage IrMn ou FeMn présente également une température de blocage plus faible que celle de la couche de PtMn.

Avec la mise en oeuvre d'une telle couche anti-ferromagnétique IrMn ou FeMn, l'intensité du champ d'anisotropie d'échange de la couche de stockage en résultant est particulièrement dépendante de la structure cubique face centrée de son réseau cristallographique, et cette intensité augmente lorsque la structure cristallographique augmente son niveau organisationnel. Pour un matériau donné, la température de blocage est essentiellement dépendante du volume de grain de sorte qu'elle peut être adaptable en modifiant l'épaisseur de la couche.

Ainsi que mentionné dans le préambule de la présente invention, la couche de stockage (40) est constituée d'une bicouche associant une couche réalisée en un matériau ferromagnétique avec une aimantation située dans le plan de la couche, au contact de la barrière tunnel, et d'une couche réalisée en un matériau anti-ferromagnétique (IrMn ou FeMn) avec une température de blocage modérée, voire faible, typiquement mais non limitativement comprise entre 120 et 220°C. Cette température de blocage doit être suffisamment élevée pour s'assurer qu'à température ambiante, c'est-à-dire hors phase d'écriture, l'aimantation de la couche de stockage soit suffisamment piégée pour conserver l'information pendant une période de plusieurs années, mais cependant pas trop élevée pour éviter un chauffage en excès de la jonction tunnel magnétique lors de chacune des opérations d'écriture, qui pourrait conduire à une dégradation des matériaux, une dépolarisation de l'aimantation de la couche de référence, ou induire une consommation électrique trop élevée. Cette couche anti-ferromagnétique IrMn (FeMn) et plus particulièrement Ir₂₀Mn₈₀ (Fe₅₀Mn₅₀) présente une épaisseur typique comprise entre 4 et 15 nm.

La couche ferromagnétique (47) constitutive de la couche de stockage, et en contact avec la barrière tunnel (42), est par exemple constituée d'un matériau choisi dans le groupe comprenant le permalloy (Ni₈₀Fe₂₀), Co₉₀Fe₁₀ ou tout autre alliage magnétique contenant du fer, du cobalt, du nickel, et présentant une épaisseur de l'ordre de 1 à 5 nm.

L'expérience démontre qu'on observe une densité importante de défauts structurels susceptibles d'apparaître dans les jonctions tunnel magnétiques en raison de l'incompatibilité structurelle inhérente à la structure cristallographique cubique centrée (001) de la barrière tunnel MgO et des couches ferromagnétiques adjacentes d'une part, et d'autre part, de la structure cristallographique cubique face centrée (111) de la couche antiferromagnétique IrMn. Ces incompatibilités structurelles ont un impact direct sur le ratio de magnétorésistance et sur la qualité de piégeage de la couche de stockage du à ces différences de structure cristallographique, qui ne filtrent plus alors de manière efficace les électrons en fonction de la symétrie de leur fonction d'onde électronique dépendante du spin, au regard de la symétrie des états de propagation dans la barrière tunnel. Or la mise en oeuvre d'une structure autre que la structure cubique face centrée (111) de la couche anti-ferromagnétique IrMn aboutit à des champs d'anisotropie d'échange plus faibles et à une plus grande coercitivité de la couche de stockage, résultats opposés à l'objectif recherché de la présente invention.

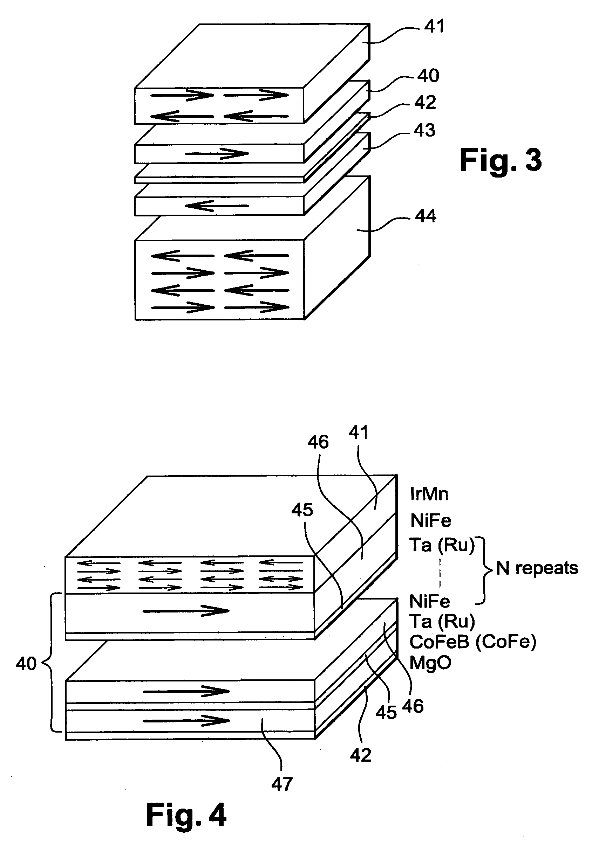

Selon une caractéristique essentielle de l'invention, et afin d'aboutir auxdits résultats, on interpose dans la bicouche constitutive de la couche de stockage, donc entre la couche ferromagnétique (47) au contact de la barrière tunnel et la couche anti-ferromagnétique IrMn, une ou plusieurs bicouches intégrant chacune une couche d'un matériau amorphe ou quasi-amorphe, tel que décrit en relation avec la figure 4.

Ce faisant, de par l'introduction de telles couches en matériau amorphe ou quasi-amorphe, on casse la cristallographie locale lors du processus de croissance et on permet le changement ou la relaxation depuis un processus de croissance cristallographique du type cubique centré à un processus de croissance cristallographique en cubique face centrée. Ce faisant, la mémoire de la structure cristallographique cubique centrée (001) induite par la ou les premières couches ferromagnétiques en contact avec la barrière tunnel, est annihilée après une ou plusieurs mises en place de la couche en matériau amorphe ou quasi-amorphe.

Selon l'invention, il n'est pas procédé à la simple mise en place d'une couche amorphe mais à la mise en place d'une bicouche d'un matériau amorphe ou quasi-amorphe (45) et d'un matériau ferromagnétique à structure cristallographique cubique face centrée (46), et notamment en un matériau constitué de permalloy (NiFe).

Le nombre N de répétitions de cette bicouche (couche amorphe ou quasi-amorphe et couche ferromagnétique à structure cubique face centrée) doit être cependant aussi réduit que possible, de telle sorte que, d'une part, le champ coercitif de la couche de stockage ainsi constituée soit faible, et d'autre part, le chauffage de ladite couche de stockage soit efficace pour permettre de favoriser les phases d'écriture.

Selon l'invention, l'épaisseur de la couche ou des couches réalisées en matériau amorphe ou quasi-amorphe est comprise entre 0,15 et 3 nm. La valeur 0,15nm est donnée à titre indicatif comme une valeur minimale pour permettre la transition de structures entre cubique centrée et cubique face centrée. La valeur 3 nm est donnée aussi à titre indicatif comme étant une valeur maximale au delà de laquelle les couches magnétiques de part et d'autre de cette couche amorphe ou quasi amorphe pourraient être trop magnétiquement découplées si la couche amorphe est non-magnétique. Si la couche amorphe est magnétique (comme par exemple en CoFeB), la valeur de 3 nm est aussi une valeur maximale pour ne pas excessivement augmenter l'épaisseur magnétique de la couche de stockage.

Ce matériau amorphe ou quasi-amorphe est avantageusement choisi dans le groupe comprenant le tantale (Ta), le cuivre (Cu), le ruthénium (Ru), la silice (SiO₂), l'oxyde de tantale (TaO), les oxydes d'aluminium (AlOₓ), les oxydes de zirconium (ZrOₓ), les oxydes de titane (TiOₓ), les oxydes de hafnium (HfOₓ), le nitrure de tantale (TaN), le nitrure de titane (TiN), les métaux de transition Co, Fe ou Ni avec ajout de bore, de zirconium, de niobium ou d'hafnium dans des proportions totales d'éléments ajoutés de 5 à 30% atomique ou un alliage de ces composés.

Ces couches sont déposées par pulvérisation cathodique ou tout autre procédé de dépôt de phase vapeur (Physical Vapor Deposition). Les oxydes ou nitrures déposés par ces méthodes incorporent en général une quantité importante de lacunes d'oxygène ou d'azote de sorte que le produit résistance x surface introduit par la couche de matériau amorphe ou quasi-amorphe est faible au regard du produit résistance x surface de la barrière tunnel. Les couches métalliques (comme par exemple CoFeB) ont quant à elles un produit résistance x surface très faible comparativement au produit résistance x surface de la barrière tunnel.

Les couches en matériau amorphe ou quasi-amorphe ainsi réalisées peuvent également être constituées d'une combinaison des matériaux précédemment cités. On peut par exemple mettre en oeuvre un composé AlZrOₓ d'une épaisseur de 0,3 nm ou une combinaison type multicouche de ces matériaux, tel que par exemple AlOₓ 0,2nm/TaOₓ 0,2nm.

Selon un second mode de réalisation de l'invention, il est également possible d'insérer des oxydes métalliques hétérogènes sous forme de fines couches, obtenus par exemple par oxydation de fines couches de composé Al₁₋ₓCuₓ, x étant compris dans une fourchette de 0,1 à 10 %. Ce type de couche a été développé en relation avec les têtes magnétorésistives utilisant les chemins de courant confinés (*current confined paths*). Comme l'aluminium a une beaucoup plus forte affinité pour l'oxygène que le cuivre, après oxydation, ces couches se retrouvent constituées de couches d'AlOₓ percées par des trous métalliques de cuivre de densité et taille relativement bien contrôlées. La densité et la taille de ces trous sont déterminées par la quantité du cuivre mélangé avec l'aluminium lors de la phase de dépôt de l'alliage AlCu préalablement à son oxydation et par les conditions d'oxydation (pression, température pendant l'oxydation).

De manière plus générale, on peut mettre en oeuvre toute forme d'alliage hétérogène de formule générale : M_{y}(NOₓ)_{1-y}, dans laquelle M désigne un métal de transition choisi dans le groupe comprenant le nickel, le cobalt et le fer, ou un métal noble ou un alliage de plusieurs métaux nobles tel que le cuivre, l'argent, l'or. NOₓ désigne alors un oxyde amorphe ou quasi-amorphe tel que SiOₓ, TiOₓ, HfOₓ, TaOₓ et MgO, ou un mélange de ces oxydes.

Ces alliages hétérogènes sont réalisés par un premier dépôt d'une fine couche du type M_{y}N_{1-y}, ladite couche étant ensuite oxydée par oxydation naturelle ou plasma. En raison de la plus grande affinité des espèces N (Si, Ti, Hf, Ta, Mg) pour l'oxygène que les métaux M, une phase de séparation intervient pendant l'oxydation de sorte que cette oxydation aboutit à la formation d'une matrice NOₓ comprenant des trous métalliques en matériau M. Ces trous peuvent également partiellement être oxydés, mais cependant à un niveau moins élevé que celui de la matrice absorbante.

L'épaisseur typique de l'alliage à déposer avant l'oxydation est comprise entre 0,15 nm et 2 nm. Par tâtonnage, on est à même de sélectionner l'épaisseur de ces couches de façon à disposer d'une part, d'une épaisseur suffisante pour permettre un changement structurel de la couche en question, mais également, pas trop épaisse de telle sorte que les couches magnétiques situées de part et d'autre de la dite couche en question demeurent suffisamment couplées ferromagnétiquement. En d'autres termes, la couche de stockage magnétique en contact avec la barrière tunnel doit conserver un champ d'échange significativement plus élevé que sa coercitivité lors des conditions normales de température, c'est-à-dire en dehors des phases d'écriture. Ce critère permet, lorsqu'une phase d'écriture a été réalisée, d'assurer un seul état stable de la couche de stockage et ce, aux conditions normales en termes de température d'utilisation de la mémoire.

Si le métal M est magnétique (Fe, Co, Ni ou un alliage à base de ceux-ci), les trous métalliques seront magnétiques de sorte qu'un fort couplage magnétique relatif existe entre les couches M à travers les couches NOₓ. Ceci permet d'utiliser des couches NOₓ relativement plus épaisses, typiquement comprises entre 0,6 et 2 nm. Cependant, si le métal M est un métal noble, le couplage intercouche à travers la couche NOₓ décroît rapidement comme une fonction de l'épaisseur de ladite couche NOₓ. Dans ce cas, on doit mettre en oeuvre des couches plus fines typiquement 0,15-1 nm pour maintenir un couplage magnétique suffisant à travers lesdites couches.

Dans la notation NOₓ, x représente une composition proche de celle d'un oxyde stable de N. Par exemple si N représente l'aluminium, AlOₓ représente une composition proche de Al₂O₃. Cependant, dans ce type d'oxyde, il existe toujours quelques lacunes d'oxygène qui font que la composition n'est pas exactement la composition idéale de l'oxyde parfaitement stçchiométrique.

Comme pour le premier mode de réalisation, il est également possible d'insérer plusieurs couches (typiquement jusqu'à 2 ou 3) de tels alliages hétérogènes dans l'empilement tout en respectant cependant l'épaisseur requise pour conserver une bonne cohérence magnétique de l'intégralité de la couche de stockage, et des propriétés d'échange de champ adaptées. En d'autres termes, les différentes couches constitutives de la couche de stockage doivent être couplées magnétiquement de manière suffisante pour réagir comme une couche magnétique unique, dont la coercivité est inférieure au champ d'anisotropie d'échange, ce dernier étant typiquement de quelques dizaines à quelques centaines d'Oersteds en mode normal, c'est-à-dire hors phase d'écriture.

Selon un troisième mode de réalisation de l'invention, la couche de matériau amorphe ou quasi-amorphe insérée dans la couche de stockage peut être obtenue par une étape d'oxydation naturelle ou par plasma intervenant lors de la croissance de la couche magnétique supérieure de la jonction tunnel. Par exemple, on peut déposer au-dessus de la barrière tunnel MgO une première couche de 2 nm d'épaisseur de CoFeB ou de CoFe à réseau cristallographique cubique centré (concentration de fer supérieure à 30 % et préférentiellement proche de 50 %). Puis on expose la structure obtenue à l'atmosphère ou sous oxygène de façon à oxyder naturellement la surface du CoFeB ou du CoFe pour aboutir à la formation d'une couche de CoFeBOₓ ou CoFeOₓ.

Après cette opération, la croissance de la couche supérieure peut être réalisée avec un matériau magnétique de type cubique face centrée tel que du CoFe, dont la concentration en fer est inférieure à 30 %, tel que par exemple le Co₉₀Feₓ ou du NiFe.

Cette technique de réalisation d'une couche d'oxyde nanométrique depuis la surface d'oxydation de la couche magnétique préalablement déposée est identique à celle précédemment développée dans le contexte de réalisation des valves de spin spéculaires (voir par exemple la publication : *Enhancement of MR ratios using thin oxyde layers in PtMn and α-Fe₂O₃-based spin valves,* Sakakima.H., Satomi. M., Sugita.Y., Kawawake,.Y., Journal of Magnetism and Magnetic Materials, 210(1), p.20-24, February 2000*).* Ces couches d'oxyde nanométriques ainsi formées sont relativement minces, quasi-amorphes, d'épaisseur voisine de 0,5 nm et présentant une densité relativement élevée en trous. Cela permet de disposer d'un couplage ferromagnétique fort au travers de telles couches. Elles sont donc adaptées dans le cadre de la présente invention.

Dans le cadre de ce mode de réalisation, il est également possible de mettre en oeuvre plusieurs de ces couches d'oxyde nanométrique dans l'empilement constitutif de la couche de stockage, et donc entre la barrière tunnel et la couche anti-ferromagnétique piégeant l'alimentation de la couche de stockage en mode normal, c'est-à-dire hors phase d'écriture.

Les mémoires obtenues, avec la jonction tunnel magnétique, conformes à l'invention permettent de disposer à la fois de rapports de magnétorésistance élevés, principalement dus à la structure cubique centrée de la barrière tunnel MgO et des couches magnétiques en contact avec ladite barrière, et un champ d'anisotropie d'échange élevé avec une coercitivité faible de la couche de stockage (avec une structure cristallographique cubique face centrée de la couche de piégeage anti-ferromagnétique), requises pour la réalisation d'une couche de stockage à champ d'anisotropie d'échange préférée dans le cadre des mémoires magnétiques à écriture assistée thermiquement.

Comme déjà dit, l'insertion d'une ou plusieurs couches ultrafines d'un matériau amorphe ou quasi-amorphe permet de découpler les deux structures cristallographiques. A titre illustratif, la présente invention a été expérimentée avec différentes configurations de la couche de stockage.
1. Couche de stockage simple et conventionnelle à base de CoFeB
2. Couche de stockage constituée d'une tricouche CoFeB/NiFe/IrMn
3. Couche de stockage constituée d'un empilement CoFeB/ Ta (0,2 nm)/NiFe/IrMn
4. Couche de stockage constituée d'un empilement CoFeB/ Ta (0,5 nm)/NiFe/IrMn

Les valeurs expérimentales de la grandeur tunnel magnétorésistance-TMR, du produit surface x résistance, R.A, du champ d'anisotropie d'échange Hₑₓ et du champ coercitif H_{c} de la couche de stockage sont reproduites dans le tableau ci-dessous.

| | **1** | **2** | **3** | **4** |
|---|---|---|---|---|
| TMR | 160% | 60% | 130% | 140% |
| R.A. en Ω. µm² | 60 | 100 | 100 | 85 |
| Hc en oersteds | 12 | 30 | 20 | 12 |
| Hex en oersteds | pas d'échange | 180 | 140 | 5 |

On observe que pour une couche conventionnelle CoFeB (exemple 1), la valeur TMR obtenue est voisine de 160 % pour un produit RA de 60 Ω.µm². On considère que ces valeurs sont la référence pour de bonnes propriétés magnétorésistives dans un empilement texturé CoFeB/MgO/CoFeB de la jonction tunnel magnétique pour une mémoire magnétique. Le champ coercitif de la couche supérieure CoFeB est également relativement faible.

Dans le cadre du second empilement proposé (CoFeB/NiFe/IrMn) (exemple 2) pour la couche de stockage, on a ajouté une couche de NiFe pour optimiser le champ d'anisotropie d'échange avec la couche anti-ferromagnétique IrMn. L'adjonction de cette couche d'IrMn sur la couche ferromagnétique induit une réduction significative de la magnétorésistance par environ la moitié de la valeur de l'échantillon n° 1, alors que le champ d'anisotropie d'échange est important (140 oersteds).

L'insertion d'une couche ultrafine de matériau quasi-amorphe de tantale (0,2 nm d'épaisseur) entre la couche magnétique CoFeB et la couche NiFe (exemple 3) permet d'améliorer la valeur de la TMR jusqu'à environ 130 % tout en maintenant la même valeur pour le champ d'anisotropie d'échange.

Une augmentation de l'épaisseur de la couche de tantale permet d'améliorer encore cette valeur de TMR jusqu'à atteindre typiquement la même valeur que celle de référence (exemple 1), mais dans ce cas, le champ d'anisotropie d'échange sur la couche supérieure CoFeB a drastiquement diminué.

En d'autres termes, l'insertion d'une couche très mince en matériau amorphe ou quasi-amorphe entre la couche ferromagnétique en contact avec la barrière tunnel et l'une des couches en contact avec la couche anti-ferromagnétique IrMn, permet d'aboutir à une valeur TMR élevée avec un champ magnétique d'anisotropie d'échange également élevé. Cependant, si l'épaisseur de cette couche est trop élevée, les couches ferromagnétiques sont totalement découplées et alors le champ d'anisotropie d'échange agissant sur la couche supérieure de CoFeB disparaît.

## Revendications

1. Elément magnétique à écriture par champ ou transfert de spin assistée thermiquement, comportant chacun :
- une couche magnétique de référence (43), dite « couche piégée », dont l'aimantation est de direction fixe;
- une couche magnétique de stockage (40), dite « couche libre », dont la direction de l'aimantation est variable, et constituée d'une couche (47) réalisée en un matériau ferromagnétique à aimantation dans le plan de la couche, couplée magnétiquement avec une couche de piégeage (41) en un matériau anti-ferromagnétique;
- une couche (42) isolante ou semi conductrice ou à chemins de courants confinés, interposée entre la couche de référence et la couche de stockage,
***caractérisé* en ce qu'**est interposée au sein de la couche de stockage, entre la couche ferromagnétique (47) au contact de la couche isolante ou semi-conductrice ou à chemins de courants confinés (42) et la couche anti-ferromagnétique (41), au moins une bicouche constituée respectivement d'un matériau amorphe ou quasi-amorphe (45) et d'un matériau (46) de même structure ou de même réseau cristallographique que la couche anti-ferromagnétique (41).

2. Elément magnétique à écriture par champ ou transfert de spin assistée thermiquement selon la revendication 1, ***caractérisé* en ce que** l'épaisseur de la couche ou des couches (45) réalisées en matériau amorphe ou quasi-amorphe est comprise entre 0,15 et 2 nm.

3. Elément magnétique à écriture par champ ou transfert de spin assistée thermiquement selon l'une des revendications 1 et 2, ***caractérisé* en ce que** le matériau amorphe ou quasi-amorphe est choisi dans le groupe comprenant le tantale (Ta), le ruthénium (Ru), la silice (SiO₂), l'oxyde de tantale (TaO), les oxydes d'aluminium (AlOₓ), les oxydes de zirconium (ZrOₓ), les oxydes de titane (TOₓ), les oxydes de hafnium (HfOₓ), le nitrure de tantale (TaN), le nitrure de titane (TiN), les métaux de transition Co, Fe ou Ni avec ajout de bore, de zirconium, de niobium ou d'hafnium dans des proportions totales d'éléments ajoutés de 5 à 30% atomique ou un alliage de ces composés.

4. Elément magnétique à écriture par champ ou transfert de spin assistée thermiquement selon l'une des revendications 1 à 3, ***caractérisé* en ce que** le dépôt de la couche de matériau amorphe ou quasi-amorphe est réalisé par pulvérisation cathodique ou tout autre procédé de dépôt de phase vapeur (Physical Vapor Deposition).

5. Elément magnétique à écriture par champ ou transfert de spin assistée thermiquement selon l'une des revendications 1 et 2, ***caractérisé* en ce que** le matériau amorphe ou quasi-amorphe est constitué d'un oxyde de métal hétérogène.

6. Elément magnétique à écriture par champ ou transfert de spin assistée thermiquement selon la revendication 5, ***caractérisé* en ce que** l'oxyde de métal hétérogène répond à la formule générale M_{y}(NOₓ)_{1-y}, dans laquelle :
▪ M représente un métal de transition choisi dans le groupe comprenant le nickel, le cobalt et le fer, ou un métal noble ou un alliage de métaux nobles, tel que le cuivre, l'argent ou l'or ;
▪ NOₓ représente un oxyde amorphe ou quasi-amorphe d'un élément N choisi dans le groupe comprenant Si, Ti, Hf, Ta, Mg ou un mélange de ces oxydes ;
▪ y est compris entre 0.1 et 10%.

7. Elément magnétique à écriture par champ ou transfert de spin assistée thermiquement selon la revendication 5, ***caractérisé* en ce que** l'oxyde de métal hétérogène répond à la formule générale (Al₁₋ₓCuₓ), x étant compris dans une fourchette de 0,1 à 10 %.

8. Elément magnétique à écriture par champ ou transfert de spin assistée thermiquement selon l'une des revendications 1 à 7, ***caractérisé* en ce que** les couches anti-ferromagnétiques (44, 41) piégeant respectivement la couche de référence (43) et la couche de stockage (40) sont réalisées à base d'alliage de manganèse, et notamment PtMn pour la couche de référence, et IrMn ou FeMn pour la couche de stockage.

9. Mémoire magnétique à écriture assistée thermiquement, dont chaque point mémoire ou chaque cellule mémoire est constitué d'un élément magnétique selon l'une des revendications 1 à 8.

10. Elément logique à écriture assistée thermiquement constitué d'un élément magnétique selon l'une des revendications 1 à 8.

## Patentansprüche

1. Magnetisches Element zum thermisch unterstützten Schreiben mittels Spin-Feld oder -Transfer, jeweils umfassend:
- eine Referenzmagnetschicht (43), "eingefangene Schicht" genannt, deren Magnetisierung von feststehender Richtung ist;
- eine magnetische Speicherschicht (40), "freie Schicht" genannt, deren Richtung der Magnetisierung variabel ist, und die aus einer Schicht (47) besteht, die aus einem ferromagnetischen Material mit Magnetisierung in der Ebene der Schicht hergestellt ist, die mit einer Einfangschicht (41) aus einem antiferromagnetischen Material magnetisch gekoppelt ist;
- eine isolierende oder halbleitende oder mit abgegrenzten Strompfaden versehene Schicht (42), die zwischen der Referenzschicht und der Speicherschicht angeordnet ist,
**dadurch gekennzeichnet, dass** in die Speicherschicht, zwischen der ferromagnetischen Schicht (47), die mit der isolierenden oder halbleitenden oder mit abgegrenzten Strompfaden versehenen Schicht (42) in Kontakt ist, und der antiferromagnetischen Schicht (41) mindestens eine Doppelschicht angeordnet ist, die aus einem amorphen oder quasi amorphen Material (45) bzw. einem Material (46) mit derselben Struktur oder demselben Kristallgitter wie die antiferromagnetische Schicht (41) besteht.

2. Magnetisches Element zum thermisch unterstützten Schreiben mittels Spin-Feld oder -Transfer nach Anspruch 1, **dadurch gekennzeichnet, dass** die Dicke der Schicht oder der Schichten (45), die aus einem amorphen oder quasi amorphen Material hergestellt ist bzw. sind, zwischen 0,15 und 2 nm beträgt.

3. Magnetisches Element zum thermisch unterstützten Schreiben mittels Spin-Feld oder -Transfer nach einem der Ansprüche 1 und 2, **dadurch gekennzeichnet, dass** das amorphe oder quasi amorphe Material aus der Gruppe ausgewählt ist, die Tantal (Ta), Ruthenium (Ru), Siliciumdioxid (SiO₂), Tantaloxid (TaO), Aluminiumoxide (AlOₓ), Zirconiumoxide (ZrOₓ), Titanoxide (TOₓ), Hafniumoxide (HfOₓ) Tantanitrid (TaN), Titannitrid (TiN), Co-, Fe- oder Ni-Übergangsmetalle mit Zusatz von Bor, Zirconium, Niob oder Hafnium in Gesamtanteilen an zugesetzten Elementen von 5 bis 30 Atom-% oder eine Legierung dieser Verbindungen umfasst.

4. Magnetisches Element zum thermisch unterstützten Schreiben mittels Spin-Feld oder -Transfer nach einem der Ansprüche 1 bis 3, **dadurch gekennzeichnet, dass** die Abscheidung der Schicht aus dem amorphen oder quasi amorphen Material durch Kathodenzerstäubung oder irgendein anderes Abscheidungsverfahren aus der Gasphase (Physical Vapor Deposition) erfolgt.

5. Magnetisches Element zum thermisch unterstützten Schreiben mittels Spin-Feld oder -Transfer nach einem der Ansprüche 1 und 2, **dadurch gekennzeichnet, dass** das amorphe oder quasi amorphe Material aus einem heterogenen Metalloxid besteht.

6. Magnetisches Element zum thermisch unterstützten Schreiben mittels Spin-Feld oder -Transfer nach Anspruch 5, **dadurch gekennzeichnet, dass** das heterogene Metalloxid der allgemeinen Formel M_{y}(NOₓ)_{1-y} entspricht, worin:
▪ M ein Übergangsmetall darstellt, das aus der Gruppe ausgewählt ist, die Nickel, Cobalt, Eisen oder ein Edelmetall oder eine Legierung von Edelmetallen wie etwa Kupfer, Silber oder Gold umfasst;
▪ NOₓ ein amorphes oder quasi amorphes Oxid eines Metalls N darstellt, das aus der Gruppe ausgewählt ist, die Si, Ti, Hf, Ta, Mg oder ein Gemisch dieser Oxide umfasst;
▪ y zwischen 0,1 und 10% ausmacht.

7. Magnetisches Element zum thermisch unterstützten Schreiben mittels Spin-Feld oder -Transfer nach Anspruch 5, **dadurch gekennzeichnet, dass** das heterogene Metalloxid der allgemeinen Formel (Al₁₋ₓCuₓ) entspricht, wobei x in einer Spanne von 0,1 bis 10% enthalten ist.

8. Magnetisches Element zum thermisch unterstützten Schreiben mittels Spin-Feld oder -Transfer nach einem der Ansprüche 1 bis 7, **dadurch gekennzeichnet, dass** die antiferromagnetischen Schichten (44, 41), die die Referenzschicht (43) bzw. die Speicherschicht (40) einschließen, auf Basis einer Manganlegierung, und insbesondere PtMn für die Referenzschicht und IrMn oder FeMn für die Speicherschicht hergestellt sind.

9. Magnetspeicher zum thermisch unterstützten Schreiben, von dem jede Speicherstelle oder jede Speicherzelle aus einem magnetischen Element nach einem der Ansprüche 1 bis 8 besteht.

10. Logikelement zum thermisch unterstützten Schreiben, das aus einem magnetischen Element nach einem der Ansprüche 1 bis 8 besteht.

## Claims

1. A magnetic element with thermally-assisted writing using a field or spin transfer, each comprising:
- a magnetic reference layer (43) referred to as the "trapped layer", the magnetisation of which is in a fixed direction ;
- a magnetic storage layer (40) called the "free layer" having a variable magnetisation direction and consisting of a layer (47) made of a ferromagnetic material with magnetisation in the plane of the layer and magnetically coupled to a magnetisation-trapping layer (41) made of an antiferromagnetic material;
- a semiconductor or confined-current-path insulating layer (42) sandwiched between the reference layer and the storage layer,
wherein one or more bilayers consisting respectively of an amorphous or quasi-amorphous material (45) and a material (46) having the same structure or the same crystal lattice as antiferromagnetic layer (41) is/are placed in the storage layer between the ferromagnetic layer (47) which is in contact with the semiconductor or confined-current-path insulating layer (42) and the antiferromagnetic layer (41).

2. A magnetic element with thermally-assisted writing using a field or spin transfer as claimed in claim 1, wherein the thickness of the layer or layers (45) made of an amorphous or quasi-amorphous material is 0.15 to 2 nm.

3. A magnetic element with thermally-assisted writing using a field or spin transfer as claimed in claims 1 and 2, wherein the amorphous or quasi-amorphous material is selected from the group comprising tantalum (Ta), ruthenium (Ru), silicon dioxide (SiO₂), tantalum oxide (TaO), aluminium oxides (AlOₓ), zirconium oxides (ZrOₓ), titanium oxides (TiOₓ), hafnium oxides (HfOₓ), tantalum nitride (TaN), titanium nitride (TiN), transition metals Co, Fe or Ni with added boron, zirconium, niobium or hafnium with the total proportion of added elements being 5 to 30% by atomic weight or an alloy of these compounds.

4. A magnetic element with thermally-assisted writing using a field or spin transfer as claimed in claims 1 to 3, wherein the layer of amorphous or quasi-amorphous material is deposited by cathode sputtering or any other physical vapour deposition (PVD) process.

5. A magnetic element with thermally-assisted writing using a field or spin transfer as claimed in claims 1 and 2, wherein the amorphous or quasi-amorphous material consists of a heterogeneous metal oxide.

6. A magnetic element with thermally-assisted writing using a field or spin transfer as claimed in claim 5, wherein the heterogeneous metal oxide has the general formula M_{y}(NOₓ)_{l-y}, where:
▪ M is a transition metal selected from the group comprising nickel, cobalt and iron or a noble metal or an alloy of noble metals such as copper, silver or gold;
▪ NOₓ is an amorphous or quasi-amorphous oxide of an element N selected from the group comprising Si, Ti, Hf, Ta, Mg or a mixture of these oxides;
▪ y is 0.1 to 10%.

7. A magnetic element with thermally-assisted writing using a field or spin transfer as claimed in claim 5, wherein the heterogeneous metal oxide has the general formula (Alₗ₋ₓCuₓ) where x varies from 0.1 to 10%.

8. A magnetic element with thermally-assisted writing using a field or spin transfer as claimed in claims 1 to 7, wherein the antiferromagnetic layers which, respectively, trap reference layer and storage layer are based on a manganese alloy, especially PtMn for the reference layer and IrMn or FeMn for the storage layer.

9. A magnetic memory with thermally-assisted writing, each storage cell of which consists of a magnetic element as claimed in any of claims 1 to 8.

10. A logic element with thermally-assisted writing consisting of a magnetic element as claimed in any of claims 1 to 8.
